# EUROPÄISCHE PATENTSCHRIFT

(11) **EP 1 664 239 B1**
(45) Veröffentlichungstag und Bekanntmachung des Hinweises auf die Patenterteilung: **30.01.2013**
(21) Anmeldenummer: 04786854.2
(22) Anmeldetag: 24.09.2004
(51) Int. Cl.: C09K 11/79, H01L 33/00

(54) **WEISS EMITTIERENDE LED MIT DEFINIERTER FARBTEMPERATUR**
WHITE-EMITTING LED HAVING A DEFINED COLOR TEMPERATURE
DIODE ELECTROLUMINESCENTE A EMISSION BLANCHE PRESENTANT UNE TEMPERATURE DE COULEUR DEFINIE

(30) Priorität: 24.09.2003 DE 10344331
(43) Veröffentlichungstag der Anmeldung: 07.06.2006
(73) Patentinhaber: OSRAM GmbH, 81543 München (DE); OSRAM Opto Semiconductors GmbH, 93055 Regensburg (DE)
(72) Erfinder: BRUNNER, Herbert, 93161 Sinzing (DE); FIEDLER, Tim, 81377 München (DE); JERMANN, Frank, 81739 München (DE); STRAUSS, Jörg, 93051 Regensburg (DE); ZACHAU, Martin, 82269 Geltendorf (DE)
(74) Vertreter: Raiser, Franz
(86) Internationale Anmeldenummer: PCT/DE2004/002138
(87) Internationale Veröffentlichungsnummer: WO 2005/031797

(56) Entgegenhaltungen:
- EP-A- 1 296 376
- WO-A-01/40403
- US-A1- 2002 003 233
- US-A1- 2002 043 926
- US-A1- 2002 105 269

## Beschreibung

### Technisches Gebiet

Die Erfindung geht aus von einer LED mit definierter, insbesondere niedriger Farbtemperatur. Darunter wird eine Farbtemperatur im Bereich 2300 bis 7000 K verstanden. Insbesondere handelt es sich um den Bereich 2700 bis 3300 K.

### Stand der Technik

Der Bereich warmweißer Farbtemperaturen, also unterhalb 3500 K, ist bisher mit kommerziell erhältlichen LEDs schwer zu realisieren. Die gängigen Leuchtstoffe vermitteln eine Farbtemperatur von mehr als 5000 K. Bisher ist daher versucht worden, warmweiße Farbtemperaturen sehr aufwendig durch die Kombination mehrerer LEDs zu erstellen, siehe beispielsweise WO 02/52901 und WO 02/52902.

Aus der EP 1 296 376 sind bereits Oxinitride verschiedener Stöchiometrie als Leuchtstoffe für die Anwendung bei weißen LED bekannt. Häufig wird dabei als Kation mindestens eines der Metalle Ca,Sr,Ba verwendet. Diese Leuchtstoffe sind vornehmlich für Tageslicht-Anwendungen gedacht.

Einfache LEDs, die sich warmweiße Lichtfarben zum Ziel gesetzt haben, basieren bisher auf UV-Chips. Aufgrund des großen Energieunterschieds zwischen dem UV-Bereich und dem kurzwelligen sichtbaren Bereich (blau) sowie der UV-bedingten , wegen der höheren Energie erhöhten, strahlungsbedingten schnelleren Alterung des Gehäuses und des Leuchtstoffvergusses erreichen diese LEDs weder die Lebensdauer noch die Effizienz von neutralweißen LEDs, wie sie bisher auf Basis von blau emittierenden Chips zur Verfügung stehen.

Eine Alternative sind RGB-LEDs auf Basis von Lumineszenzkonversions-LEDs mit Sulfid- und Thiogallat-Leuchtstoffen, siehe beispielsweise WO 01/24229. Es hat sich jedoch gezeigt, dass die dort vorgeschlagenen Leuchtstoff bzgl. Langzeitstabilität und Effizienz bei Verwendung von Hochleistungschips, die eine hohe Betriebstemperatur erreichen, nicht den Anforderungen genügen. Die Sulfide sind chemisch instabil gegen Feuchte und die Thiogallate, die dort vorgeschlagen sind, zeigen ein ausgeprägtes Temperaturquenching. Bei Kontakt mit Wasser zersetzen sich die bekannten Sulfid-Leuchtstoffe zudem unter Bildung von giftigen Gasen wie Schwefelwasserstoff.

Eine andere Lösung, die nachweislich eine hohe Lebensdauer ermöglicht und eine hohe Effizienz bei sehr gutem Farbwiedergabeindex besitzt , ist bisher nicht bekannt. Die Verwendung einer Mischung aus dem bekanten YAG:Ce sowie einem Rot-Leuchtstoff wie beispielsweise Sr2Si5N8:Eu führt nur zu maximalen Ra-Werten von 85 bis 90, siehe dazu WO 01/40403.

Leuchtstoffe des Typs Oxinitridosilikat sind an sich unter der Kurzformel MSiON bekannt; siehe beispielsweise "On new rare-earth doped M-Si-Al-O-N materials" , J. van Krevel, TU Eindhoven 2000, ISBN 90-386-2711-4, Kap. 6. sie sind mit Tb dotiert. Emission wir erreicht bei Anregung durch 365 nm oder 254 nm.

Ein neuartiger Leuchtstoff ist aus der noch unveröffentlichten EP-PA 02 021 117.8 (Docket 2002P15736) bekannt. Er besteht aus Eu- oder Eu,Mn-koaktiviertem Oxinitridosilikat der Formel MSi₂O₂N₂ (M = Ca, Sr, Ba).

### Darstellung der Erfindung

Es ist Aufgabe der vorliegenden Erfindung, eine weiße LED mit definierter Lichtfarbe, entsprechend einer Farbtemperatur gemäß dem Oberbegriff des Anspruchs 1 bereitzustellen, deren Ra möglichst hoch ist und mindestens Ra=80 erreicht, insbesondere höher als Ra=85, bevorzugt höher 90.

Diese Aufgabe wird durch die kennzeichnenden Merkmale des Anspruchs 1 gelöst. Besonders vorteilhafte Ausgestaltungen finden sich in den abhängigen Ansprüchen.

Bisher gibt es keine zufriedenstellende Realisierung dieser Aufgabenstellung. Es wird nun vorgeschlagen, eine Leuchtstoff-Mischung aus einer speziellen, hocheffizienten grün emittierenden Sr-Sion-Phase sowie einem roten, an sich bekannten Nitrid-Leuchtstoff zu verwenden.

Die LED ist als weiß emittierende Lumineszenzkonversions-LED ausgeführt, bestehend aus einer Primär-Strahlungsquelle, die ein Chip ist, der im Blauen Spektralbereich emittiert, und einer davor geschalteten Schicht zweier Leuchtstoffe, die die Strahlung des Chip teilweise konvertieren, wobei der erste Leuchtstoff aus der Klasse der Oxinitridosilikate besteht, mit einem Kation M und der grundsätzlichen Formel M_{(1-c)}Si₂O₂N₂:D_{c}, wobei M als wesentlichen Bestandteil Sr umfasst und wobei D eine Dotierung mit zweiwertigem Europium ist, wobei M = Sr oder M = Sr_{(1-x-y)}Ba_{y}Caₓ mit 0 ≤ x+y < 0,5 verwendet wird, wobei das Oxinitridosilikat vollständig oder überwiegend aus der hochtemperaturstabilen Modifikation HT besteht, und dass der zweite Leuchtstoff ein Nitridosilikat der Formel (Ca,Sr)₂Si₅N₈:Eu ist, wobei eine Farbtemperatur von 2300 bis 7000 K erzielt wird.

Erfindungsgemäß wird ein Leuchtstoff verwendet, der ein Oxinitridosilikat der Formel MSi₂O₂N₂ (M = Ca, Sr, Ba) darstellt, das mit zweiwertigem Eu aktiviert ist, unter evtl. weiterer Zugabe von Mn als Koaktivator, wobei der Leuchtstoff überwiegend oder allein, also mit mehr als 50 % des Leuchtstoffs, aus der HT-Phase besteht. Diese HT-Modifikation zeichnet sich dadurch aus, dass sie breitbandig anregbar aus, nämlich in einem weiten Bereich von 200 bis 480 nm, dass sie eine extrem hohe Stabilität gegen äußere Einflüsse besitzt, also bei 150°C keine messbare Degradation zeigt, und dass sie eine extrem gute Farbortstabilität unter wechselnden Bedingungen zeigt (zwischen 20 und 100 °C wenig Drift nachweisbar). Dieser Leuchtstoff wird im folgenden oft Sr-Sion:Eu genannt.

Dieser Leuchtstoff ist vor allem grün emittierend mit einer Dominanzwellenlänge im Bereich 550 bis 570 nm.

Bei der Herstellung des neuartigen Leuchtstoffs kommt es vor allem auf eine hohe Temperatur an, der Synthesebereich liegt bei 1300 bis 1600 °C. Ein anderer bestimmender Faktor ist die Reaktivität der Ausgangskomponenten. Diese sollte möglichst hoch sein.

Insbesondere kann dieser Leuchtstoff von einer LED, vor allem vom Typ InGaN, effizient angeregt werden.

Der aus EP-PA 02 021 117.8 bekannte Leuchtstoff MSi₂O₂N₂:Eu (M = Ca, Sr, Ba) ist im Falle der Sr-dominierten Ausführungsform mit M = Sr_{(1-x-y)}Ba_{y}Caₓ mit 0 sx+y< 0,5, im folgenden Sr-Sion genannt, nur schwer beherrschbar. Obwohl einzelne Versuchsbedingungen hervorragende Ergebnisse liefern, fehlt bislang eine Richtschnur, um zuverlässig gewünschte Ergebnisse zu erhalten. Hinzu kommt eine gewisse Neigung, dass sich bei hoher Temperaturbelastung die Effizienz des Leuchtstoffs verringert und der Farbort zu stark variiert. Bevorzugt sind insbesondere: y = 0 mit 0 ≤ x ≤ 0,3 und x= 0 mit 0 ≤ y≤ 0,1.

Überraschenderweise hat sich nun gezeigt, dass sich die beiden Phasen in ihrer Eignung als Leuchtstoff grundlegend unterscheiden. Während die NT-Phase als Eudotierter Leuchtstoff praktisch nicht zu gebrauchen ist, und nur schwach orange-rot emittiert, zeigt die HT-Phase eine hervorragende Eignung als Leuchtstoff, der grün emittiert. Im Normalfall liegt eine Mischung vor, die breitbandig beide Emissionen erkennen lässt. Entscheidend ist daher, die HT-Phase möglichst rein, mit mindestens 50 % Anteil, bevorzugt mindestens 70 %, besonders bevorzugt mindestens 85% Anteil herzustellen.

Dafür ist ein Glühprozess erforderlich, der bei mindestens 1300 °C, aber nicht mehr als 1600 °C durchgeführt wird. Bevorzugt ist ein Temperaturbereich von etwa 1450 bis 1580 °C, da bei geringerer Temperatur zunehmend NT-Phase entsteht und bei höherer Temperatur der Leuchtstoff zunehmend schlechter verarbeitbar ist, und ab etwa 1600 °C als hart gesinterte Keramik oder Schmelze vorliegt. Der optimale Temperaturbereich hängt von der genauen Zusammensetzung und den Eigenschaften der Ausgangsmaterialien ab.

Besonders wichtig für das Herstellen eines effizienten Leuchtstoffs des Typs Sr-Sion ist ein Ansatz der Ausgangsprodukte, der im wesentlichen stöchiometrisch ist unter Verwendung der Grundkomponenten SiO ₂, SrCO ₃ sowie Si ₃ N ₄. Sr steht hier beispielhaft stellvertretend für M. Die Abweichung sollte insbesondere 10 %, bevorzugt 5 %, des idealen stöchiometrischen Ansatzes nicht überschreiten, wobei auch die etwaige Zugabe eines Schmelzmittels, wie es oft üblich ist, dabei eingeschlossen ist. Besonders bevorzugt ist eine maximale Abweichung von 1 %. Hinzu kommt ein Vorläufer für den Europium-Beitrag der Dotierung, der beispielsweise als Oxid Eu ₂ O ₃ realisiert wird. Diese Erkenntnis steht im Gegensatz zu der bisherigen Vorgehensweise, die Grundkomponente SiO ₂ deutlich unterstöchiometrisch zuzugeben. Besonders überraschend ist diese Erkenntnis auch deswegen, weil andere als Leuchtstoff empfohlene Sione wie Ba-Sion gemäß der Lehre von EP-PA 02 021 117.8 gerade im SiO₂-Unterschuss hergestellt werden sollen.

Ein entsprechender Ansatz für das Sr-Sion MSi₂O₂N₂ verwendet daher 11 bis 13 Gew.-% SiO ₂ , 27 bis 29 Gew.-% Si ₃ N ₄ , Rest SrCO ₃. Ba- und Ca- Anteile an M werden entsprechend als Carbonat zugesetzt. Europium wird entsprechend der gewünschten Dotierung, beispielsweise als Oxid oder Fluorid, als Ersatz für SrCO ₃ zugesetzt. Der Ansatz MSi₂O₂N₂ meint dabei auch etwaige Abweichungen von der exakten Stöchiometrie, soweit sie hinsichtlich der Ladungserhaltung ausgeglichen sind.

Als besonders günstig hat sich erwiesen, dass die Ausgangskomponenten des Wirtsgitters, insbesondere Si ₃ N ₄ , möglichst hohe Reinheit besitzen. Besonders bevorzugt ist daher Si ₃ N ₄ , das aus der flüssigen Phase, ausgehend beispielsweise von Siliziumtetrachlorid, synthetisiert ist. Als kritisch hat sich insbesondere die Verunreinigung mit Wolfram und Kobalt, erwiesen. Hier sollte die Verunreinigung möglichst gering sein, insbesondere sollte sie jeweils kleiner 100 ppm, insbesondere kleiner 50 ppm, sein, bezogen auf diese Vorläufersubstanzen. Des weiteren ist eine möglichst hohe Reaktivität vorteilhaft, sie lässt sich durch die reaktive Oberfläche (BET) quantifizieren. Diese sollte mindestens 6 m²/g betragen, vorteilhaft mindestens 8 m²/g. Auch die Verunreinigung an Aluminium und Calcium, bezogen auf diese Vorläufersubstanz Si ₃ N ₄, sollte möglichst unter 100 ppm liegen.

Bei Abweichung von der oben angegebenen Verfahrensführung in bezug auf stöchiometrischen Ansatz und Temperaturführung entstehen als unerwünschte Fremdphasen in zunehmendem Maße Nitridosilikate MxSiyNz wie etwa M2Si5N8, wenn die SiO₂-Zugabe zu niedrig angesetzt wird, so dass ein Stickstoffüberschuss entsteht. Obwohl diese Verbindung an sich ein bemerkenswerter Leuchtstoff ist, ist sie in Zusammenhang mit der Synthese des Sr-Sions genauso wie andere Nitridosilikate äußerst störend, weil diese Fremdphasen die grüne Strahlung des Sr-Sions absorbieren und evtl. in die bekannte rote Strahlung der Nitridosilikate umwandeln. Umgekehrt entstehen bei zu hoher SiO₂-Zugabe Sr-Silikate wie beispielsweise Sr₂SiO₄ weil ein Sauerstoffüberschuss entsteht. Beide Fremdphasen absorbieren die nutzbare grüne Emission oder führen zumindest zu Gitterdefekten wie Leerstellen, die die Effizienz des Leuchtstoffs stark beeinträchtigen. Als Anhaltspunkt dient die Richtschnur, dass der Anteil der Fremdphasen möglichst unter 15 %, bevorzugt sogar unter 5 %, liegen soll. Dies korrespondiert im XRD-Spektrum des synthetisierten Leuchtstoffs mit der Forderung, dass beim XRD-Ablenkwinkei 2 Θ im Bereich 25 bis 32° die Intensität aller Fremdphasenpeaks kleiner als 1/3, bevorzugt kleiner als % , besonders bevorzugt kleiner als 1/5, der Intensität des die HT-Modifikation kennzeichnenden Hauptpeaks bei etwa 31,8° sein soll. Dies gilt vor allem für die Fremdphasen vom Typ SrxSiyNz, insbesondere Sr2Si5N8.

Im Falle einer optimierten Verfahrensführung lässt sich zuverlässig eine Quanteneffizienz von 80 bis deutlich über 90 % erzielen. Dagegen wird bei unspezifischer Verfahrensführung die Effizienz typisch im Bereich von höchstens 50 bis 60 % Quanteneffizienz liegen.

Es lässt sich somit ein Leuchtstoff herstellen, der ein Oxinitridosilikat der Formel MSi₂O₂N₂ (M = Ca, Sr, Ba) darstellt, das mit zweiwertigem Eu aktiviert ist, unter evtl. weiterer Zugabe von Mn als Koaktivator, wobei der Leuchtstoff überwiegend oder allein, also mit mehr als 50 % des Leuchtstoffs, aus der HT-Phase besteht. Diese HT-Modifikation zeichnet sich dadurch aus, dass er breitbandig anregbar ist, insbesondere in einem weiten Bereich von 250 bis 480 nm, dass er eine extrem hohe Stabilität gegen äußere Einflüsse besitzt, also bei 150°C an Luft keine messbare Degradation zeigt, dass er eine extrem gute Farbortstabilität unter wechselnden Bedingungen zeigt. Weitere Pluspunkte sind seine geringe Absorption im Roten, was besonders bei Leuchtstoffmischungen vorteilhaft ist. Dieser Leuchtstoff wird im folgenden oft Sr-Sion:Eu genannt. Ein Überwiegen der HT-Modifikation ist u.a. daran erkennbar, dass der kennzeichnende Peak der NT-Modifikation im XRD-Spektrum bei etwa 28,2 ° eine Intensität von weniger als 1:1, bevorzugt weniger als 1:2, im Vergleich zum Peak mit höchster Intensität aus der Dreiergruppe der Reflexe der HT-Modifikation, die im XRD-Spektrum bei 25 bis 27° liegen, aufweist. Die hier aufgeführten XRD-Spektren beziehen sich jeweils auf eine Anregung durch die bekannte Cu-K_{α} Linie.

Bei gleicher Aktivatorkonzentration zeigt dieser Leuchtstoff ein anderes Emissionsverhalten als die NT-Variante gleicher Stöchiometrie. Die Halbwertsbreite der HT-Variante ist im Falle der optimierten HT-Variante wesentlich geringer als bei der einfachen fremdphasen- und defekthaltigen Mischung und liegt im Bereich 70 bis 80 nm, während die einfache Fremdphasen- bzw. defekthaltige Mischung eine Halbwertsbreite von etwa 110 bis 120 nm zeigt. Die dominante Wellenlänge ist bei der HT-Modifikation generell kürzer, typisch 10 bis 20 nm kürzer, als bei einer deutlich fremdphasenhaltigen Probe. Hinzu kommt, dass die Effizienz der hochreinen HT Modifikation typisch um mindestens 20 % höher, teilweise deutlich noch höher, als bei der NT-dominierten oder hoch fremdphasenhaltigen Mischung liegt.

Ein Merkmal eines ausreichend geringen Anteils der NT-Modifikation und Fremdphasen ist eine Halbwertsbreite (FWHM) der Emission von weniger als 90 nm. Denn je geringer der Anteil an Fremdphasen, desto geringer ist der Anteil der spezifischen orange-roten Emission der fremdphasenreichen Modifikation, insbesondere der Nitridosilikat-Fremdphasen Sr-Si-N-Eu wie vor allem Sr2Si5N8:Eu.

Hilfreich sind neben der verringerten Halbwertsbreite die oben angegebenen typischen Reflexe im XRD-Spekrum, die die andere Kristallstruktur verdeutlichen.

Der vorherrschende Peak im XRD-Spektrum der HT-Modifikation ist der Peak bei etwa 31.7°. Weitere prominente Peaks sind die drei Peaks etwa gleicher Intensität zwischen 25 und 27° (25,3 und 26,0 und 26,3°), wobei der Peak mit kleinster Ablenkung der intensivste ist. Ein weiterer intensiver Peak ist 12,6°.

Dieser Leuchtstoff ist vor allem grün emittierend mit einer Dominanzwellenlänge im Bereich 550 bis 570 nm, insbesondere 555 bis 565 nm.

Auch eine geringfügige Beimengung der Gruppe AIO als Ersatz der Gruppe SiN im Molekül des Oxinitridosilikats der Formel MSi₂O₂N₂ ist möglich, insbesondere bis maximal 30 % des SiN-Anteils.

Beide Phasen des Sr-Sion:Eu können analog zu den zwei strukturell unterschiedlichen Wirtsgittermodifikationen kristallisieren und jeweils über die Ansatzstöchiometrie SrSi2O2N2:Eu hergestellt werden. Geringe Abweichungen von dieser Stöchiometrie sind möglich. Die mit Eu dotierten Wirtsgitter lumineszieren überraschenderweise beide bei Anregung im Blauen oder UV, allerdings je nach Wirtsgittermodifikation mit anderer Emissionsfarbe. Die NT-Modifikation zeigt eine orangefarbene Emission, die HT-Modifikation eine grüne Emission bei etwa λ_{dom} = 560 nm mit prinzipiell deutlich höherer Effizienz. Je nach Dotiergehalt und Dotiermaterial (Eu oder Eu, Mn) sowie den relativen Anteilen der HT- und NT-Modifikation +lässt sich eine gewünschte Eigenschaft des Leuchtstoffs genau einstellen.

Ein Vorzug der HT-Phase ist die über einen sehr weiten Spektralbereich gleichmä-βig gute Anregbarkeit bei nur wenig variierender Quanteneffizienz.

Außerdem hängt die Lumineszenz der HT-Modifikation in einem weiten Temperaturbereich nur schwach von der Temperatur ab. Damit ist erstmals ein grün emittierender Leuchtstoff, bevorzugt für LED-Anwendungen, gefunden, der ohne besondere Maßnahmen zur Stabilisierung auskommt. Dies zeichnet ihn besonders gegen die bisher als aussichtsreichste Kandidaten angesehenen Leuchtstoffe für diese Aufgabe aus, nämlich Thiogallat-Leuchtstoffe oder Chlorosilikate.

Die Sionverbindungen mit M = (Sr,Ba), bevorzugt ohne Ba oder mit Ba-Anteil bis zu 10 %, stellen effiziente Leuchtstoffe mit einem weiten Bereich der Emissionsmaxima dar. Diese liegen meist kurzwelliger als bei reinem Sr-Sion, bevorzugt zwischen 520 und 565 nm. Der erreichbare Farbraum lässt sich außerdem durch geringe Beigaben (bevorzugt bis 30 mol-%) an Ca und/oder Zink erweitern; dadurch werden die Emissionsmaxima eher in den langwelligeren Bereich, verglichen mit reinem Sr-Sion, verschoben, sowie durch partiellen Ersatz (bis 25 mol-%) von Si durch Ge und/oder Sn.

Eine weitere Ausführungsform ist die Teilsubstitution von M, insbesondere Sr, durch drei- oder einwertige Ionen wie La3+ oder Li+ oder Na+ oder Y3+. Bevorzugt ist ein Anteil dieser Ionen von maximal 20 mol-% des M.

Überraschend ist nun mit dem Sr-Sion der HT-Phase ein Leuchtstoff gefunden, der sich exakt auf eine grüne Peakemission, beispielsweise der Wellenlänge 560 nm (Dominanzwellenlänge), einstellen lässt. Der Leuchtstoff wandelt das Licht einer blauen oder UV-LED mit einer Quanteneffizienz von deutlich mehr als 80 % um. Die lumenbewertete Effizienz ist vergleichbar mit der typischer weißer LEDs auf YAG:Ce-Basis.

Als weiterer Vorteil ist anzusehen, daß die Emissionsfarbe der Lumineszenzkonversions-LED praktisch unabhängig von der Betriebstemperatur ist, damit kann die LED gut bei unterschiedlichen Außentemperaturen betriebe werden und ist farbortstabil dimmbar.

Die zweite Leuchtstoff-Komponente ist das eingangs erwähnte Nitrid des Typs (Sr,Ca)2Si5N8:Eu in geeigneter Zusammensetzung. Mit diesen beiden Leuchtstoffen, deren typische Quanteneffizienzen deutlich über 80 % liegen, und die beide sehr gut im Bereich kurzwelliger blauer Strahlung absorbieren, vor allem auch bei 450 bis 465 nm, wo die stärksten Chips zur Verfügung stehen, lassen sich effiziente warmweiße LEDs mit einem Farbwiedergabeindex Ra von bis zu 95 bereitstellen. Ein typischer Ra-Wert liegt je nach gewünschter Optimierung bei 85 bis 95.

Der besondere Vorteil gerade dieser Kombination ist, dass beide Leuchtstoffe ein ähnliches Temperaturverhalten zeigen, was die Effizienz der Lumineszenz betrifft, wodurch vorteilhaft dimmbare LEDs bei möglichst konstantem Farbort ermöglicht werden.

Die Temperaturabhängigkeit der Lumineszenz ist signifikant geringer als bei den bisher vorgeschlagenen sulfidischen Leuchtstoffen, beide Arten von Leuchtstoffen außerdem chemisch deutlich stabiler als ihre bisher bekannten sulfidischen Alternativen (SrS:Eu und Thiogallate). Die beiden Nitrid-basierten Leuchtstoffe und ihre möglichen Zersetzungsprodukte sind weitgehend ungiftig, was beim Aspekt der Umweltschonung eine Rolle spielt.

Für den Einsatz in der LED können Standardverfahren eingesetzt werden. Insbesondere ergeben sich folgende Realisierungsmöglichkeiten.

Erstens das Eindispergieren des Leuchtstoff in den LED-Verguss, beispielsweise ein Silikon oder Epoxidharz, und anschließendes Aufbringen durch beispielsweise Vergießen, Drucken, Spritzen o.ä. Zweitens Einbringen des Leuchtstoffs in eine sog. Pressmasse und anschließendes Spritzpressverfahren. Drittens Methoden der chipnahen Konversion, d.h. Aufbringen der Leuchtstoffe bzw. deren Mischung auf der Wafer-Prozessings-Ebene, nach dem Vereinzeln der Chips und nach der Montage im LED-Gehäuse. Hierzu wird insbesondere auf DE 101 53 615 und WO 01/50540 verwiesen.

Die Erfindung betrifft weiterhin ein Beleuchtungssystem mit LEDs wie oben beschrieben, wobei das Beleuchtungssystem weiterhin elektronische Komponenten enthält. diese vermitteln beispielsweise die Dimmbarkeit. Eine weitere Aufgabe der Elektronik ist die Ansteuerung einzelner LEDs oder auch Gruppen von LEDs diese Funktionen können durch vorbekannte elektronische Elemente realisiert sein.

### Figuren

Im folgenden soll die Erfindung anhand zweier Ausführungsbeispiele näher erläutert werden. Es zeigen:
- Figur 1: ein Emissionsspektrum eines Oxinitridosilikats;
- Figur 2: das Reflektionsspektrum dieses Oxinitridosilikats;
- Figur 3: ein Halbleiterbauelement, das als Lichtquelle für warmweißes Licht dient;
- Figur 4: die Lage des Farborts verschiedener Chargen einer warmweißen LED;
- Figur 5: ein Emissionsspektrum einer Lichtquelle gemäß Figur 3;
- Figur 6: weitere Emissionsspektren von Lichtquellen gemäß Figur 3;
- Figur 7: ein Beleuchtungssystem auf Basis warmweißer LEDs.

### Beschreibung der Zeichnungen

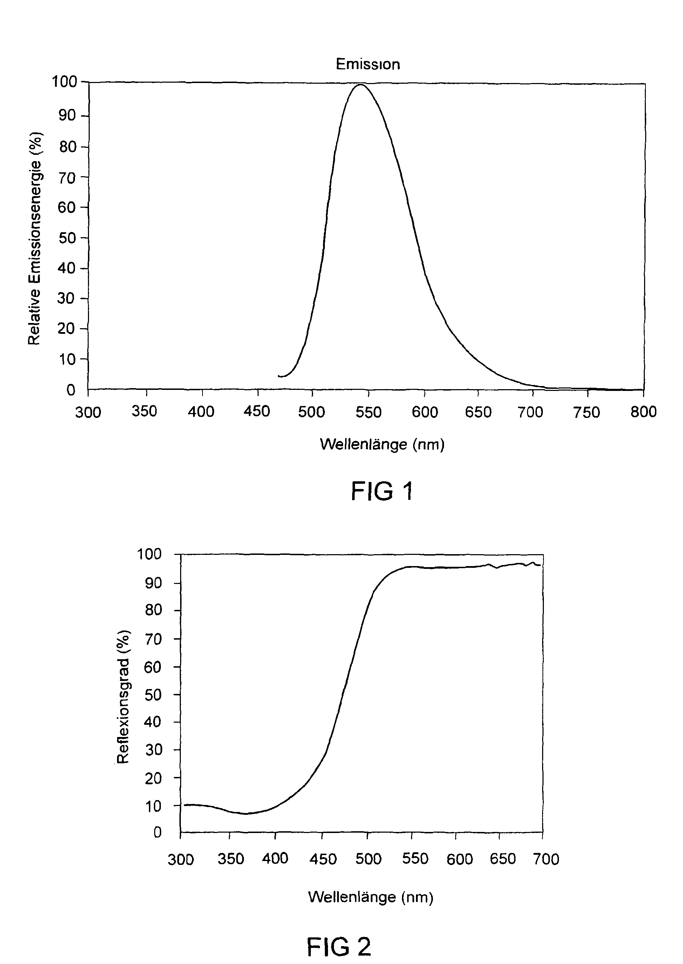

Ein konkretes Beispiel für den erfindungsgemäßen Leuchtstoff ist in Figur 1 gezeigt. Es handelt sich um die Emission des Leuchtstoffs SrSi₂N₂O₂:(5 % Eu²⁺) in HT-Modifikation, bei dem der Eu-Anteil 5 mol-% der von Sr besetzten Gitterplätze ausmacht. Das Emissionsmaximum liegt bei 540 nm, die mittlere Wellenlänge λdom bei 558 nm. Der Farbort ist x=0,357; y=0,605. Die Anregung erfolgte bei 460 nm. die FWHM ist 76 nm. Die Quanteneffizienz liegt bei etwa 90 %. Der Farbort ist x = 0,357, y = 0,605.

Figur 2 zeigt das diffuse Reflexionsspektrum dieses Leuchtstoffs. Es zeigt ein ausgeprägtes Minimum im Bereich unter 440 nm, das somit die gute Anregbarkeit in diesem Bereich demonstriert.

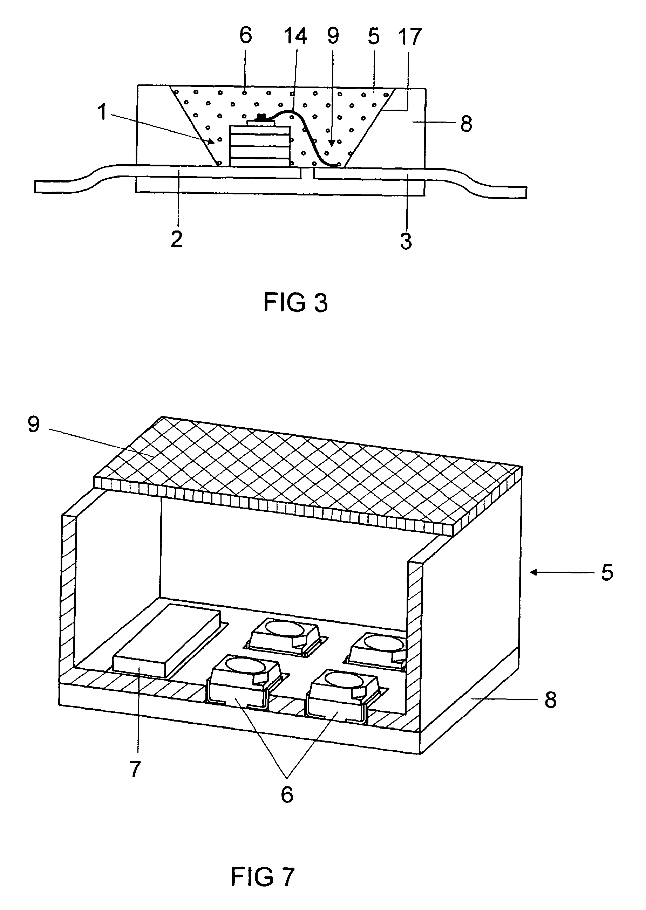

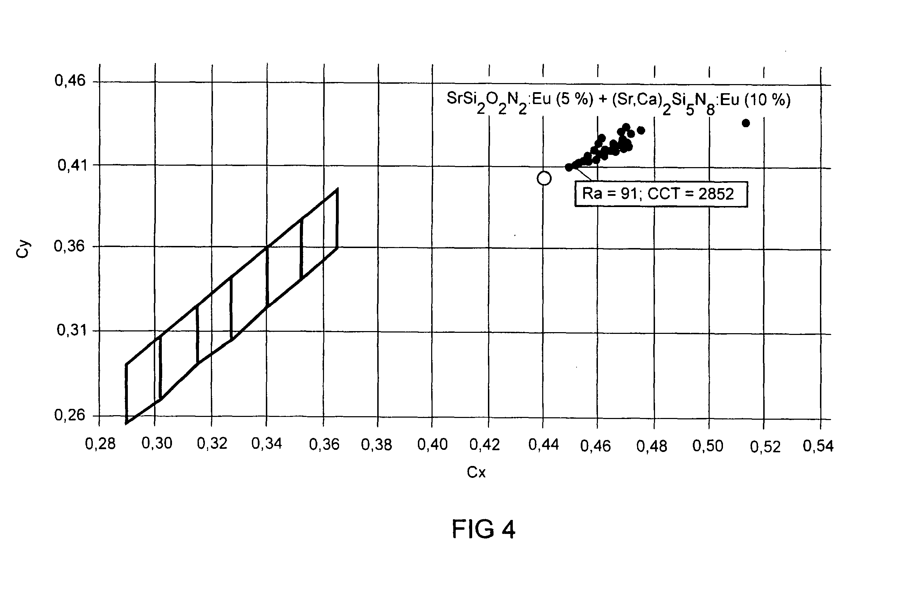

Der Aufbau einer Lichtquelle für weißes Licht ist in Figur 3 explizit gezeigt. Die Lichtquelle ist ein Halbleiterbauelement mit einem Chip 1 des Typs InGaN mit einer Peakemissionswellenlänge von 440 bis 470 nm, beispielsweise 460 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Epoxidgießharz (80 bis 90 Gew.-%) und Leuchtstoffpigmente 6 aus einer Mischung zweier Leuchtstoffe (weniger als 20 Gew.-%) enthält. Ein erster Leuchtstoff ist das als erstes Ausführungsbeispiel vorgestellte Oxinitridosilikat mit 5 %Eu, der zweite ist ein rot emittierender Leuchtstoff, hier insbesondere (Sr,Ca)₂Si₅N₈:Eu(10%). Die Ausnehmung 9 hat eine Wand 17, die als Reflektor für die Primär- und Sekundärstrahlung vom Chip 1 bzw. den Pigmenten 6 dient. Die Kombination der blauen Primär- und grünen bzw. roten Sekundärstrahlung mischt sich zu warmweiß mit hohem Ra von 91 und Farbtemperatur von 2850 K. Der angestrebte Farbort liegt im Bereich x = 0,44 bis 0,48 sowie y = 0,40 bis 0,44, siehe Figur 4. Das Verhältnis Sr zu Ca beim Nitridosilikats ist hier 9:1.

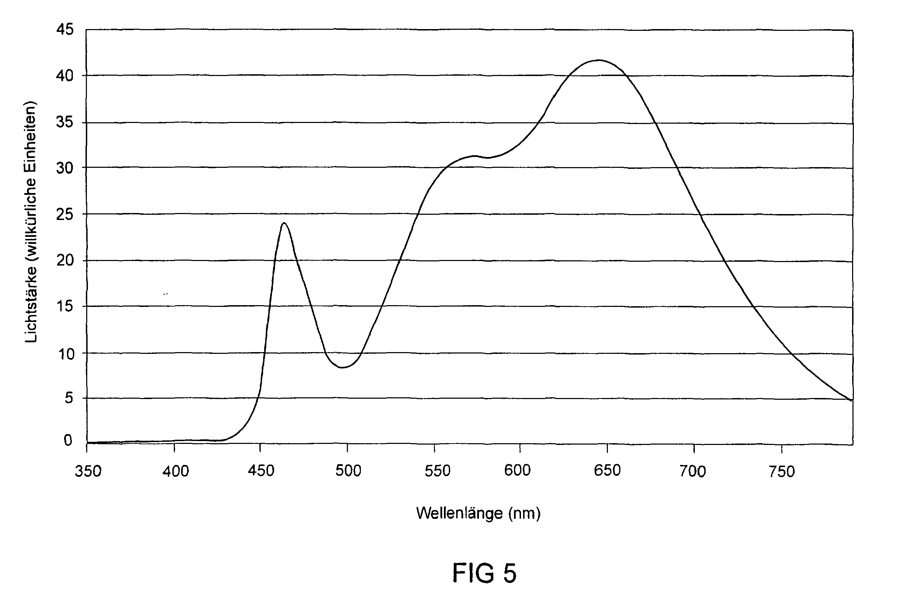

Das zugehörige Emissionsspektrum ist in Figur 5 gezeigt. Es zeigt die Intensität in willkürlichen Einheiten als Funktion der Wellenlänge (in nm). deutlich sind die Peaks der Primärstrahlung bei 460 nm, des Oxinitridosilikats bei etwa 560 nm und des Nitridosilikats bei etwa 640 nm zu erkennen.

Generell enthält das Nitridosilikat MₐSi_{y}N_{z}:Eu als permanente Komponente Sr und als Beimischung Ca in einem Anteil von 0 bis 60 mol-%. Insbesondere ist das bevorzugte Nitridosilikat durch die Formel (Sr₁₋ₓCaₓ)₂Si_{y}N_{z} mit x = 0 bis 0,6 charakterisiert, wobei hier y = 5 und z = 8 und generell y,z ≤ 10 gewählt wird. Im allgemeinen wird die Effizienz und der Farbwiedergabeindex Ra durch die Höhe der Dotierung mit Eu optimiert, bevorzugt ist ein Wert für Eu von 5 bis 10 mol-% des M. Die Zugabe von Ca gestattet es insbesondere, eine allzu hohe Zugabe des Dotiermittels Eu zu vermeiden. Es hat sich gezeigt, dass zur Erzielung hoher Farbwiedergabeindices eine Zugabe von Ca und eine Begrenzung des Eu-Anteils empfehlenswert ist. Für Ra > 90 kann daher x bis maximal 0,2 (bevorzugt x bis 0,1) gewählt werden, und gleichzeitig Eu bevorzugt im Bereich 3 bis 15 mol-% von M (bevorzugt 5 bis 10 mol-%) angesetzt werden. Gute Ergebnisse mit hohem Ra lassen sich auch für 0,2 < x < 0,55 erzielen, wenn gleichzeitig Eu auf 1 bis 5 mol-% von M gesetzt wird.

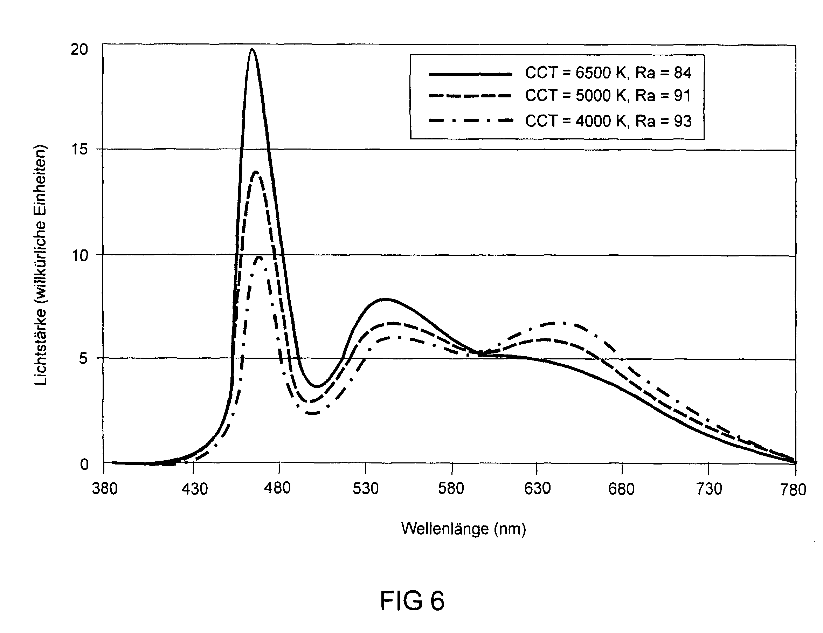

In Figur 6 sind LEDs mit höherer Farbtemperatur gezeigt. Zur Erzielung höherer Farbtemperaturen als etwa 3300 K muss die Gesamtleuchtstoffkonzentration im Vergleich zum ersten Ausführungsbeispiel reduziert werden, wodurch ein höherer transmittierter Blau-LED-Anteil resultiert sowie der Anteil des Grünleuchtstoffs (Oxinitridosilikat) im Verhältnis zum Rotleuchtstoff (Nitridosilikat) erhöht werden. Es wurde eine LED mit 460 nm Peakwellenlänge als Primärlichtquelle und blauer Emitter verwendet. Eingesetzte Leuchtstoffe sind hier konkret als Oxinitridosilikat Sr-SiON:Eu(5%) und als Nitridosilikat SrCaSiN:Eu(3%).

Bei Verwendung einer kürzerwelligen LED sinkt der Ra-Wert. Beispielsweise zeigt sich, dass bei Verwendung einer primären LED mit 450 nm Peakwellenlänge der Ra unter 80 bei 6500 K Farbtemperatur sinkt.

In Figur 7 ist ein Beleuchtungssystem 5 gezeigt, bei dem neben warmweiß emittierenden LEDs 6 auch die Steuerelektronik 7 in einem Gehäuse 8 untergebracht ist. mit 9 ist eine Abdeckung bezeichnet.

## Patentansprüche

1. Weiß emittierende LED mit definierter Farbtemperatur, als Lumineszenzkonversions-LED ausgeführt, bestehend aus einer Primär-Strahlungsquelle, die ein Chip ist, der im blauen Spektralbereich emittiert, und einer davor geschalteten Schicht zweier Leuchtstoffe, die beide die Strahlung des Chips teilweise konvertieren, **dadurch gekennzeichnet, dass** der erste Leuchtstoff aus der Klasse der Oxinitridosilikate besteht, mit einem Kation M und der grundsätzlichen Formel M_{(1-c)}Si₂O₂N₂:D_{c}, wobei M als wesentlichen Bestandteil Sr allein oder in Kombination mit Ba und/oder Ca umfasst, und wobei D eine Dotierung mit zweiwertigem Europium ist, wobei M = Sr oder M = Sr_{(1-x-y)}Ba_{y}Caₓ mit 0 ≤ x+y < 0,5 verwendet wird, und wobei weiterhin ein Teil von M durch Li und/oder La und/oder Na und/oder Y und/oder Zn gebildet sein kann, und wobei weiterhin ein Teil von SiN durch AlO ersetzt sein kann, und wobei weiterhin ein Teil von D durch Mn gebildet sein kann, und wobei das Oxinitridosilikat vollständig oder überwiegend aus der hochtemperaturstabilen Modifikation HT besteht, und dass der zweite Leuchtstoff ein Nitridosilikat der Formel (Ca,Sr)₂Si₅N₈:Eu ist, wobei eine Farbtemperatur von 2300 bis 7000 K erzielt wird und gleichzeitig eine Farbwiedergabe von wenigstens Ra = 80 erzielt wird.

2. LED nach Anspruch 1, **dadurch gekennzeichnet, dass** der Anteil des Eu beim Oxinitridosilikat zwischen 0,1 und 20 mol-% von M ausmacht.

3. LED nach Anspruch 1, **dadurch gekennzeichnet, dass** bis zu 30 mol-% von M durch Ba und/oder Ca und/oder Zn gebildet ist.

4. LED nach Anspruch 1, **dadurch gekennzeichnet, dass** bis zu 30 mol-% von M durch Li und/oder La und/oder Na und/oder Y gebildet ist.

5. LED nach Anspruch 1, **dadurch gekennzeichnet, dass** bis zu 30 mol-% von SiN durch AlO ersetzt ist.

6. LED nach Anspruch 1, **dadurch gekennzeichnet, dass** bis zu 30 mol-% von Eu durch Mn ersetzt ist.

7. LED nach Anspruch 1, **dadurch gekennzeichnet, dass** der Chip ein InGaN-Chip ist.

8. LED nach Anspruch 1, **dadurch gekennzeichnet, dass** die LED die weiße Lichtfarbe durch Farbmischung nach dem RGB-Prinzip erzielt, wobei die Primäremission der blauen LED eine Peakwellenlänge von 430 bis 470 nm besitzt..

9. LED nach Anspruch 8, **dadurch gekennzeichnet, dass** die Emission des Chips eine Peakwellenlänge im Bereich 450 bis 465 nm hat.

10. LED nach Anspruch 1, **dadurch gekennzeichnet, dass** die Emission des Oxinitridosilikats eine dominante Wellenlänge λ_{dom} im Bereich 550 bis 570 nm hat.

11. LED nach Anspruch 1, **dadurch gekennzeichnet, dass** das Nitridosilikat Sr als permanente Komponente und Ca in einem Anteil von 0 bis 60 mol-% enthält.

12. LED nach Anspruch 1, **dadurch gekennzeichnet, dass** die Emission des Nitridosilikats eine dominante Wellenlänge λ_{dom} im Bereich 620 bis 660 nm hat.

13. LED nach Anspruch 1, **dadurch gekennzeichnet, dass** ein Ra von mindestens 85 erzielt wird.

14. Beleuchtungssystem mit einer LED nach Anspruch 1, **dadurch gekennzeichnet, dass** das System eine Elektronik zur Ansteuerung einzelner LEDs oder auch Gruppen von LEDs enthält.

15. Beleuchtungssystem nach Anspruch 14, wobei die elektronische Steuerung Mittel enthält, die Dimmbarkeit vermitteln.

## Claims

1. White-emitting LED with a defined colour temperature, designed as a luminescence conversion LED, comprising a primary radiation source, which is a chip that emits in the blue spectral region, with in front of it a layer of two phosphorus, both of which partially convert the radiation of the chip, **characterized in that** the first phosphor is from the class of the oxynitridosilicates having a cation M and the empirical formula M_{(1-c)}Si₂O₂N₂:D_{c}, where M comprises Sr as the main constituent alone or in combination with Ba and/or Ca and D is a doping with divalent Europium, M = Sr or M = Sr_{(1-x-y)}Ba_{y}Caₓ with 0 ≤ x+y < 0.5 being used, and where furthermore a proportion of M can be formed by Li and/or La and/or Na and/or Y and/or Zn, and where furthermore a proportion of SiN can be replaced by AlO, and where furthermore a proportion of D can be formed by Mn, and where the oxynitridosilicate completely or predominantly comprising the high-temperature-stable modification HT, and **in that** the second phosphor is a nitridosilicate of formula (Ca, Sr)₂Si₅N₈:Eu, producing a colour temperature of from 2300 to 7000 K and at the same time achieving a colour rendering of at least Ra = 80.

2. LED according to Claim 1, **characterized in that** in the oxynitridosilicate the Eu fraction makes up between 0.1 and 20 mol% of M.

3. LED according to Claim 1, **characterized in that** up to 30 mol% of M is formed by Ba and/or Ca and/or Zn.

4. LED according to Claim 1, **characterized in that** up to 30 mol% of M is formed by Li and/or La and/or Na and/or Y.

5. LED according to Claim 1, **characterized in that** up to 30 mol% of SiN is formed by AlO.

6. LED according to Claim 1, **characterized in that** up to 30 mol% of Eu is formed by Mn.

7. LED according to Claim 1, **characterized in that** the chip is an InGaN chip.

8. LED according to Claim 1, **characterized in that** the LED achieves the white luminous color by color mixing with the RGB principle, with the primary emission of the blue LED having a peak wavelength of from 430 to 470 nm.

9. LED according to Claim 8, **characterized in that** the emission from the chip has a peak wavelength in the range from 450 to 465 nm.

10. LED according to Claim 1, **characterized in that** the emission of the oxynitridosilicate has a dominant wavelength λ_{dom} in the range from 550 to 570 nm.

11. LED according to Claim 1, **characterized in that** the nitridosilicate contains Sr as a permanent component, and Ca in a proportion of from 0 to 60 mol%.

12. LED according to Claim 1, **characterized in that** the emission of the nitridosilicate has a dominant wavelength λ_{dom} in the range from 620 to 660 nm.

13. LED according to Claim 1, **characterized in that** an Ra of at least 85 is achieved.

14. Illumination system having the LED according to Claim 1, **characterized in that** the system includes electronics for driving the individual LEDs or groups of LEDs.

15. Illumination system according to Claim 14, in which the electronic control includes means which impart dimmability.

## Revendications

1. Diode électroluminescente (DEL) à émission de lumière blanche à température de couleur définie, exécutée en tant que DEL à conversion de luminescence, formée d'une source de rayonnement primaire qui est une puce émettant dans le domaine spectral bleu et d'une couche, placée avant celle-ci, de deux substances luminescences qui convertissent toutes les deux partiellement le rayonnement de la puce, **caractérisée en ce que** la première substance luminescente appartient à la classe des oxynitridosilicates, avec un cation M et présentant la formule fondamentale M_{(1-c)}Si₂O₂N₂: D_{c}, M comprenant, en tant que constituant principal, Sr seul ou combiné à Ba et/ou Ca, et D étant un dopage avec de l'europium bivalent, où M = Sr ou M = Sr_{(1-x-y)} Ba_{y}Caₓ avec 0 ≤ x+y < 0,5, et une partie de M pouvant, en outre, être formée par Li et/ou La et/ou Na et/ou Y et/ou Zn et une partie de SiN pouvant, en outre, être remplacée par AlO et une partie de D pouvant, en outre, être formée par Mn, et l'oxynitridosilicate étant formé, complètement ou majoritairement, par la modification HT stable à haute température, et **en ce que** la seconde substance luminescente est un nitridosilicate de formule (Ca, Sr)₂Si₅N₈:Eu, une température de couleur allant de 2 300 K à 7 000 K étant atteinte et une restitution de couleur d'au moins Ra = 80 étant en même temps obtenue.

2. DEL selon la revendication 1, **caractérisée en ce que** l'Eu représente une part comprise entre 0,1 mol% et 20 mol% de M dans l'oxynitridosilicate.

3. DEL selon la revendication 1, **caractérisée en ce que** jusqu'à 30 mol% de M est formé par Ba et/ou Ca et/ou Zn.

4. DEL selon la revendication 1, **caractérisée en ce que** jusqu'à 30 mol% de M est formé par Li et/ou La et/ou Na et/ou Y.

5. DEL selon la revendication 1, **caractérisée en ce que** jusqu'à 30 mol% de SiN est remplacé par AlO.

6. DEL selon la revendication 1, **caractérisée en ce que** jusqu'à 30 mol% de Eu est remplacé par Mn.

7. DEL selon la revendication 1, **caractérisée en ce que** la puce est une puce InGaN.

8. DEL selon la revendication 1, **caractérisée en ce que** la DEL produit la lumière de couleur blanche grâce à un mélange de couleurs selon le principe rouge-vert-bleu, l'émission primaire de la DEL bleu ayant une longueur d'onde de crête comprise entre 430 nm et 470 nm.

9. DEL selon la revendication 8, **caractérisée en ce que** l'émission de la puce a une longueur d'onde de crête comprise entre 450 nm et 465 nm.

10. DEL selon la revendication 1, **caractérisée en ce que** l'émission de l'oxynitridosilicate a une longueur d'onde dominante λ_{dom} comprise entre 550 nm et 570 nm.

11. DEL selon la revendication 1, **caractérisée en ce que** le nitridosilicate contient Sr comme composant permanent et Ca dans une proportion allant de 0 mol%- à 60 mol%.

12. DEL selon la revendication 1, **caractérisée en ce que** l'émission du nitridosilicate a une longueur d'onde dominante λ_{dom} comprise entre 620 nm et 660 nm.

13. DEL selon la revendication 1, **caractérisée en ce qu'** une Ra d'au moins 85 est obtenue.

14. Système d'éclairage comprenant une DEL selon la revendication 1, **caractérisé en ce que** le système contient un dispositif électronique pour commander des DEL individuelle ou bien des groupes de DEL.

15. Système d'éclairage selon la revendication 14, le dispositif électronique contenant des moyens pour obtenir une atténuation de la lumière.
